# EUROPEAN PATENT APPLICATION

(11) **EP 4 776 816 A1**
(43) Date of publication of application: **15.07.2026**
(21) Application number: 24874039.1
(22) Date of filing: 30.08.2024
(51) Int. Cl.: H10K 71/10, H10K 85/50, H10K 30/10, H10K 30/50

(54) **PREPARATION METHOD FOR PEROVSKITE THIN FILM, THIN FILM, PEROVSKITE CELL, AND STACKED CELL**

(30) Priority: 07.10.2023 CN 202311289096
(71) Applicant: Tongwei Solar (Chengdu) Co., Ltd., Chengdu, Sichuan 610299 (CN)
(72) Inventor: FENG, Qirui, Chengdu, Sichuan 610299 (CN); XING, Guoqiang, Chengdu, Sichuan 610299 (CN); HU, Yuchao, Chengdu, Sichuan 610299 (CN); ZHANG, Yifeng, Chengdu, Sichuan 610299 (CN)
(74) Representative: Dehns Germany Partnerschaft mbB
(86) International application number: PCT/CN2024/115844
(87) International publication number: WO 2025/073220

(57) **Abstract**

A method for preparing a perovskite thin film, a thin film, a perovskite cell, and a laminated cell. The preparation method includes: a bottom buried layer is prepared, where the bottom buried layer includes alkali metal formate; a porous thin film including a compound with a chemical formula being BX₂ is formed on the bottom buried layer; and the compound with the chemical formula being BX₂ in the porous thin film is allowed to react with a compound with a chemical formula being AX to obtain a perovskite thin film.

## Description

### Related Application

The present application claims the priority of Chinese patent application No. CN202311289096.3, filed with China National Intellectual Property Administration on October 7, 2023 and entitled "a method for preparing a perovskite thin film, a thin film, a perovskite cell, and a laminated cell", the entire contents of which are incorporated herein by reference.

### Technical Field

The present application relates to the technical field of perovskite batteries, and in particular to a method for preparing a perovskite thin film, a thin film, a perovskite cell, and a laminated cell.

### Background

Perovskite solar cells are solar cells that use perovskite-type organic compound semiconductor with a chemical formula being BX₂ as a light-absorbing material.

A perovskite thin film may be prepared by using a two-step method in the traditional art. During sequential deposition using the two-step method, using Pbl₂ as an example, a Pbl₂ thin film prepared through multi-source vapor deposition has a relatively-dense shape, making, during the subsequent preparation of the perovskite thin film, it difficult for the organic cation applied via spin coating to fully react with the Pbl₂, thus resulting in excessive Pbl₂ residue at the bottom. The excess unreacted Pbl₂ severely affects the performance of the photovoltaic cells and accelerates device degradation.

### Summary

According to various embodiments of the present application, a method for preparing a perovskite thin film, a thin film, a perovskite cell, and a laminated cell are provided.

In a first aspect, an embodiment of the present application provides a method for preparing a perovskite thin film. The preparation method includes:
a bottom buried layer is prepared, where the bottom buried layer includes alkali metal formate;
a porous thin film containing a compound with a chemical formula being BX₂ is formed on the bottom buried layer; and
the compound with the chemical formula being BX₂ in the porous thin film is allowed to react with a compound with a chemical formula being AX to obtain a perovskite thin film;
wherein, B is a metal cation, A is an organic amine cation or an alkali metal cation, and X is a halogen ion or a halogen-like anion.

In some embodiments, a step of preparing the bottom buried layer includes the following operations.

The alkali metal formate is added to a first solvent to obtain a first solution.

The first solution is coated on a substrate to obtain the bottom buried layer.

In some embodiments, a concentration of the alkali metal formate in the first solution is about 1 mg/mL to about 2 mg/mL.

In some embodiments, a density of a coated surface of the first solution is about 10 µL/cm² to about 25 µL/cm².

In some embodiments, the first solvent includes at least one of ethanol and octanol.

In some embodiments, a step of coating the first solution on the substrate to obtain the bottom buried layer includes:
spin coating is performed with the first solution for about 25 s to about 35 s at a rotary speed of about 3500 rpm to about 4500 rpm, and annealing is performed for about 8 min to about 10 min at about 95 °C to about 105 °C.

In some embodiments, a step of forming, on the bottom buried layer, the porous thin film containing the compound with the chemical formula being BX₂ includes:
multi-source vapor deposition is, on the bottom buried layer, performed on the compound with the chemical formula being BX₂ to form a film layer, where a thickness of the film layer is about 200 nm to about 400 nm;
annealing is performed on the film layer at about 95 °C to about 105 °C to form the porous thin film.

In some embodiments, a step of allowing the compound with the chemical formula being BX₂ in the porous thin film to react with the compound with the chemical formula being AX to obtain the perovskite thin film includes:
a second solution is coated on the porous thin film, wherein the second solution includes the compound with the chemical formula being AX.

In some embodiments, an alkali metal in the alkali metal formate includes at least one of lithium, sodium, potassium, rubidium, and cesium.

In some embodiments, the alkali metal formate includes at least one of lithium formate, sodium formate, potassium formate, rubidium formate, and cesium formate.

In some embodiments, the metal cation includes at least one of Pb₂⁺ and Sn₂⁺.

In some embodiments, the organic amine cation includes at least one of CH₃NH₃⁺ and NH₂CH = NH₂⁺.

In some embodiments, the alkali metal cation includes at least one of Cs⁺ and Rb⁺.

In some embodiments, the halogen ion is selected from at least one of Cl⁻, Br, and I⁻.

In some embodiments, the halogen-like anion is selected from at least one of CN⁻, SCN⁻, OCN⁻, and SeCN⁻.

In a second aspect, an embodiment of the present application provides a thin film, including a perovskite thin film prepared by the method for preparing a perovskite thin film of the first aspect.

In a third aspect, an embodiment of the present application provides a perovskite cell, including the thin film of the second aspect.

In a fourth aspect, an embodiment of the present application provides a laminated cell, including the perovskite cell of the third aspect.

The details of one or more embodiments of the present application are set forth in the accompanying drawings and the description below. Other features, objects, and advantages of the present application will become apparent from the specification, drawings, and claims.

### Brief Description of the Drawings

In order to more clearly illustrate the technical solutions in the embodiments of the present application or the traditional art, the drawings used in the technical description of the embodiments or the traditional art will be briefly described below. It is apparent that the drawings in the following descriptions are merely some embodiments of the present application. Other drawings can be obtained from those skilled in the art according to disclosed drawings without any creative work.
Fig. 1 is a flowchart of a method for preparing a perovskite thin film according to an embodiment of the present application.
Fig. 2 is a flowchart of S130 in a method for preparing a perovskite thin film according to an embodiment of the present application.
Fig. 3 is a flowchart of S150 in a method for preparing a perovskite thin film according to an embodiment of the present application.
Fig. 4 is a Scanning Electron Microscope (SEM) diagram of a Pbl₂ thin film according to Comparative example 1 of the present application.
Fig. 5 is an SEM diagram of a Pbl₂ porous thin film according to Embodiment 1 of the present application.
Fig. 6 is an SEM diagram of a perovskite thin film according to Embodiment 4 of the present application.
Fig. 7 is an SEM diagram of a perovskite thin film according to Embodiment 1 of the present application.
Fig. 8 is an SEM diagram of a perovskite thin film according to Embodiment 5 of the present application.
Fig. 9 is a box plot of Photoelectric Conversion Efficiency (PCE) of perovskite batteries according to Embodiment 2, Comparative example 1, and Embodiment 4 of the present application.
Fig. 10 is a schematic diagram of aging test results for perovskite batteries according to Embodiment 2 and Comparative example 1 of the present application.

### Detailed Description of the Embodiments

The technical solutions in the embodiments of the present application will be clearly and completely described below in combination with the drawings in the embodiments of the present application. It is apparent that the described embodiments are only part of the embodiments of the present application, not all the embodiments. Based on the embodiments in the present application, all other embodiments obtained by those ordinary skilled in the art without creative work shall fall within the protection scope of the present application.

In the traditional art, a perovskite thin film can be prepared by a two-step method. During the sequential deposition process using the two-step method, taking Pbl₂ as an example, the morphology of the Pbl₂ thin film prepared by multi-source evaporation is relatively dense, making it difficult for the organic cation subsequently applied by spin coating to fully react with the Pbl₂ during the preparation of the perovskite thin film, resulting in excessive unreacted Pbl₂ remaining at the bottom. Such excess unreacted Pbl₂ can adversely affect the performance of the photovoltaic cell and accelerate device degradation.

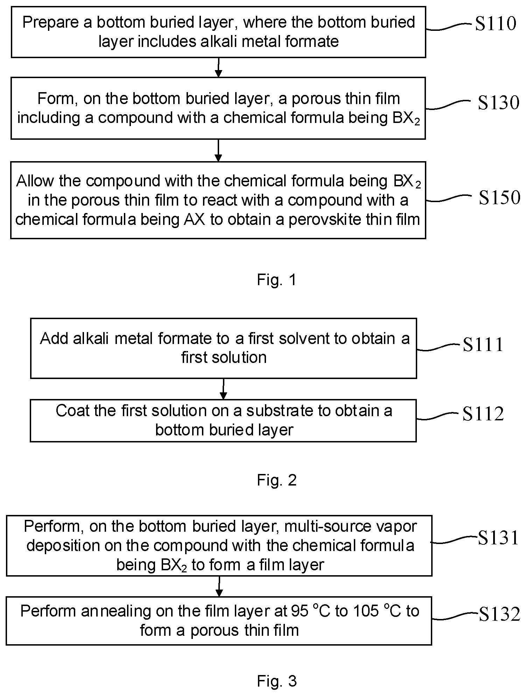

Based on this, in a first aspect, an embodiment of the present application provides a method for preparing a perovskite thin film. Referring to Fig. 1, the preparation method includes S110, S130 and S150.

At S110, a bottom buried layer is prepared, where the bottom buried layer includes alkali metal formate.

In S110, formate ions in the alkali metal formate contained in the bottom buried layer are relatively small in size, and easily migrate when being heated, such that, during upward movement, the formate ions may move though crystal boundaries in the metal halide, thereby causing the metal halide thin film to form a porous structure. In some embodiments, an alkali metal in the formate of the present application includes any one of lithium, sodium, potassium, rubidium, and cesium. Optional, the alkali metal formate of the present application includes one or more of sodium formate, potassium formate, rubidium formate, and cesium formate, and "a plurality of" refers to two or more. Further optional, the above alkali metal formate includes the sodium formate.

Alkali metal ions facilitate oriented crystallization, thereby sequentially forming the porous thin film with a good orientation. More specifically, the alkali metal ions allow holes in the porous thin film to be able to extend through in a thickness direction of the porous thin film. Compared to staggered holes, this porous thin film with a good orientation more facilitate the entering of cation to its bottom during subsequent reaction. Under the combined action of an alkali metal ion and a formate ion, a metal halide thin film forms a porous thin film with a good orientation, and holes in the porous thin film become passages for organic amine cation or alkali metal cation to enter the metal halide thin film, allowing metal halide in the porous thin film to fully react, even those located in a bottom layer of the porous thin film.

In some embodiments, referring to Fig. 2, S110 includes S111 and S112.

At S111, the alkali metal formate is added to a first solvent to obtain a first solution.

At S112, the first solution is coated on a substrate to obtain the bottom buried layer. It may be understood that, the bottom buried layer may be directly or indirectly prepared on a substrate.

In some embodiments, the concentration of the alkali metal formate in the first solution is about 1 mg/mL to about 2 mg/mL, optionally about 1.2 mg/mL to about 1.8 mg/mL; and further optionally about 1.3 mg/mL to about 1.7 mg/mL. More specifically, the concentration of the alkali metal formate in the first solution is 1 mg/mL-2 mg/mL, including any point value within the numerical range. For example, the concentration of the alkali metal formate in the first solution is 1 mg/mL, 1.1 mg/mL, 1.2 mg/mL, 1.3 mg/mL, 1.4 mg/mL, 1.5 mg/mL, 1.6 mg/mL, 1.7 mg/mL, 1.8 mg/mL, 1.9 mg/mL, or 2.0 mg/mL. In some embodiments, the density of the coated surface of the first solution is about 10 µL/cm² to about 25 µL/cm², including any point value within the numerical range. For example, the density of the coated surface of the first solution is 10 µL/cm², 12 µL/cm², 15 µL/cm², 18 µL/cm², 20 µL/cm², 22 µL/cm², 24 µL/cm², or 25 µL/cm².

The concentration of the formate and/or the coating areal density are selected as described above to achieve an appropriate pore density and pore structure of the metal halide thin film, thereby ensuring the performance of the resulting perovskite cell. If the concentration of the formate and/or the coating areal density is relatively low, the pore density of the metal halide thin film may be too low, or it may be difficult to form a porous and loose structure. If the concentration of the formate is relatively high, the metal halide thin film may be damaged, or the film layer may become excessively loose, which would adversely affect the performance of the finally prepared perovskite cell.

Optionally, the first solvent includes at least one of ethanol and octanol. The first solvent may be the ethanol, the octanol, or a mixture of the ethanol and the octanol.

In some embodiments, S112 includes:
spin coating is performed with the first solution for about 25 s to about 35 s at a rotary speed of about 3500 rpm to about 4500 rpm, and annealing is performed for 8 min-10 min at about 95 °C to about 105 °C.

In some of the embodiments, the rotary speed for performing spin coating with the first solution is 3500 rpm-4500 rpm, including any point value within the numerical range. For example, the rotary speed for performing spin coating with the first solution is 3500 rpm, 3600 rpm, 3700 rpm, 3800 rpm, 3900 rpm, 4000 rpm, 4200 rpm, or 4500 rpm. The time for performing spin coating with the first solution is 25 s-35 s, including any point value within the numerical range. For example, the time for performing spin coating with the first solution is 25 s, 26 s, 28 s, 30 s, 32 s, 34 s, or 35 s. An annealing temperature of the first solution is 95 °C-105 °C, including any point value within the numerical range. For example, the annealing temperature of the first solution is 95 °C, 98 °C, 100 °C, 102 °C, 104 °C, or 105 °C. An annealing time of the first solution is 8 min-10 min, including any point value within the numerical range. For example, the annealing time of the first solution is 8 min, 9 min, or 10 min.

At S130, a porous thin film containing a compound with a chemical formula being BX₂ is formed on the bottom buried layer.

In S130, B is metal cation, and X is a halogen ion or halogen-like anion. In some embodiments, the metal cation includes at least one of Pb₂⁺ and Sn₂⁺; the halogen ion includes at least one of Cl⁻, Br, and I⁻; and the halogen-like anion includes at least one of CN⁻, SCN⁻, OCN⁻, and SeCN⁻.

Exemplarily, BX₂ may be at least one of Pbl₂, PbCl₂, PbBr₂, SnI₂, SnCl₂, and SnBr₂, but is not limited to a compound listed above. Optional, the BX₂ includes the PbI₂. The porous thin film may contain only one compound or a plurality of compounds with the chemical formula being BX₂.

In some embodiments, the porous thin film may be formed by using a vacuum method, such as thermal evaporation, close-spaced sublimation, gas-phase transport deposition, or chemical vapor deposition. Optional, the porous thin film is formed by means of multi-source vapor deposition.

In some embodiments, referring to Fig. 3, S130 includes the following steps.

At S131, multi-source vapor deposition is, on the bottom buried layer, performed on the compound with the chemical formula being BX₂ to form a film layer.

In some of the embodiments, the thickness of the film layer is about 200 nm to about 400 nm and includes any point value within the thickness range. For example, the thickness of the film layer is 200 nm, 220 nm, 250 nm, 280 nm, 300 nm, 320 nm, 350 nm, 380 nm, or 400 nm.

At S132, annealing is performed on the film layer at about 95 °C to about 105 °C to form the porous thin film.

In some of the embodiments, the annealing temperature in S132 is 95 °C-105 °C, including any point value within the temperature range. For example, the annealing temperature of the film layer is 95 °C, 98 °C, 99 °C, 100 °C, 101 °C, 103 °C, or 105 °C.

It is to be noted that, in S131, a temperature at the substrate is lower, and generally, a temperature of a carrier plate does not exceed 75 °C. In S132, during annealing, the formate ions can migrate in the compound with the chemical formula being BX₂ at 95 °C-105 °C, so as to form the porous thin film. Another reason in the present application that the alkali metal formate is used as a preparation material of the bottom buried layer is that the formate ion is a small molecule with lower melting and boiling points, and can migrate in a large number at 95 °C-105 °C. If other acid radical ions are used, for example, sodium propionate is used to prepare the bottom buried layer, and a molecular weight of propionate ions is larger than that of the formate ions, such that it is difficult for the propionate ions to move along the crystal boundaries in the metal halide. In another aspect, it is difficult for the propionate ions to migrate at 95 °C-105 °C, preventing the formation of the porous thin film.

At S150, the compound with the chemical formula being BX₂ in the porous thin film is allowed to react with a compound with a chemical formula being AX to obtain a perovskite thin film.

In S150, A is organic amine cation or alkali metal cation, and X is a halogen ion or halogen-like anion. In some embodiments, the organic amine cation includes at least one of CH₃NH₃⁺ and NH₂CH = NH₂⁺; the alkali metal cation includes at least one of Cs⁺ and Rb⁺; the halogen ion includes at least one of Cl⁻, Br, and I⁻; and the halogen-like anion includes at least one of CN⁻, SCN⁻, OCN⁻, and SeCN⁻.

Exemplarily, AX may be at least one of methylamine iodine, methylamine bromide, methylamine iodine, or methylamine bromide, but is not limited to a compound listed above. The AX reacting with the BX₂ may be one or several compounds. A perovskite material with a chemical formula being ABX₃ is prepared after the AX reacts with the BX₂.

In some embodiments, S150 includes S151.

At S151, a second solution is coated on the porous thin film, wherein the second solution includes the compound with the chemical formula being AX.

Optionally, the AX may be coated on the porous thin film by a solution method (such as spin coating, scraper coating, slit coating, screen printing, inkjet printing, spray coating, or ultrasonic atomization), and holes in the porous thin film become passages for the organic amine cation or alkali metal cation to enter the metal halide thin film, such that metal halide in the metal halide thin film fully reacts.

To sum up, the embodiments of the present application provide the method for preparing a perovskite thin film. The bottom buried layer is prepared before a metal halide thin film (a thin film containing the compound with the chemical formula being BX₂) is formed, the bottom buried layer includes the alkali metal formate, and formate ions move upward due to heat and are relatively small, such that during upward movement, the formate ions may move through crystal boundaries in the metal halide, causing the metal halide thin film to form a porous structure. Alkali metal ions facilitate oriented crystallization, under the combined action of the alkali metal ion and the formate ion, the metal halide thin film forms the porous thin film with a good orientation, and holes in the porous thin film become passages for organic amine cation or alkali metal cation to enter the metal halide thin film, allowing metal halide in the porous thin film to fully react, even those located in a bottom layer of the porous thin film. In the perovskite thin film prepared by the present application, the metal halide fully reacts, such that excessively-unreacted metal halide is prevented from affecting the performance of perovskite solar cells.

Furthermore, the preparation of the bottom buried layer by the present application does not affect the preparation flow of the metal halide thin film, and no additional steps are required in the subsequent process, such that the process flow is simpler and is more suitable for industrial production.

The preparation method provided in the present application can solve the problem at present that, during two-step sequential deposition, a relatively-dense shape of a Pbl₂ thin film prepared through multi-source vapor deposition makes it difficult for organic cation applied via spin coating to fully react with PbI₂. Therefore, the organic amine cation or alkali metal cation can fully react with the metal halide (e.g., PbI₂) via the porous thin film.

Although a porous Pbl₂ layer having an ordered array structure may also be prepared by combining a Succinimide (SA) additive and a nanoimprint technology in the traditional art, the preparation method forms a hydrogen bond by introducing the SA into a Pbl₂ precursor solution, so as to form a porous PbI₂-SA thin film, and then a PbI₂-SA ordered array structure is obtained by the nanoimprint technology. Therefore, although solving the dense problem of the Pbl₂ thin film, the preparation method conflicts with preparation of the Pbl₂ thin film using multi-source vapor deposition in industrial production, and subsequently needs to combine with the nanoimprint technology, such that the process is too tedious. Compared with the above preparation method, the preparation method provided in the present application is more suitable for preparation of the Pbl₂ thin film using multi-source vapor deposition, and thus is simpler in process.

In a second aspect, an embodiment of the present application provides a thin film, including a perovskite thin film prepared by the method for preparing a perovskite thin film of the first aspect. It may be understood that, the thin film may only be a perovskite thin film, or a combination of the perovskite thin film and other thin films.

In a third aspect, an embodiment of the present application provides a perovskite cell, including the thin film of the second aspect.

In some embodiments, a method for preparing the perovskite cell includes the following steps.

A substrate is provided, where the substrate is any substrate known in the art that is suitable for formation of the perovskite thin film thereon, so as to prepare the perovskite cell. For example, the substrate is a transparent conductive substrate, a transport layer (a hole transport layer or an electron transport layer) or a combined structure of the transport layer and other structures (e.g., a crystalline silicon cell and/or a passivation layer). The substrate may be of a planar structure, or may also be a textured structure.

In an example of using the substrate as a crystalline silicon cell, the method for preparing the perovskite cell further includes the following steps.

A transport layer is sputtered on the crystalline silicon cell, where the bottom buried layer is prepared on the transport layer.

Alternatively, the transport layer is sputtered on the crystalline silicon cell, and then a passivation layer is formed on the transport layer, where the bottom buried layer is prepared on the passivation layer.

In some of the embodiments, the step of sputtering the transport layer on the crystalline silicon cell includes the following operation.

A layer of hole transport material (e.g., nickel oxide, PEDOT:PSS, Cu₂O, PTAA, poly-TPD, or c-OTPD) or electron transport material is sputtered on the crystalline silicon cell through Physical Vapor Deposition (PVD), so as to prepare the transport layer.

In some of the embodiments, the step of sputtering the transport layer on the crystalline silicon cell, and then forming a passivation layer on the transport layer, where the bottom buried layer is prepared on the passivation layer includes the following operations.

The layer of hole transport material or electron transport material is sputtered on the substrate through PVD, so as to obtain the transport layer.

Then, [4-(9H-carbazole-9-yl)ethyl]phosphoric acid (2-PACz) or [2-(3,6-dimethoxy-9H-carbazole-9-yl)ethyl]phosphoric acid (MeO-2PACz) is added to an ethanol solution, spin coating is performed for about 25 s to about 35 at a rotary speed of about 3500 rpm to about 4500 rpm, and annealing is performed for about 8 min to about 10 min at about 95 °C to about 105 °C.

Optionally, the hole transport material includes at least one of nickel oxide, PEDOT:PSS (poly(3,4-ethylenedioxythiophene):polystyrene sulfonic acid), cuprous oxide, PTAA (poly[bis(4-phenyl)(2,4,6-trimethylphenyl)amine]), and poly-TPD (poly[bis(4-phenyl)(4-butylphenyl)amine]);

In some of the embodiments, the rotary speed for performing spin coating on the ethanol solution of the 2-PACz is 3500 rpm-4500 rpm, including any point value within the numerical range. For example, the rotary speed for performing spin coating on the ethanol solution of the 2-PACz is 3500 rpm, 3600 rpm, 3700 rpm, 3800 rpm, 3900 rpm, 4000 rpm, 4200 rpm, or 4500 rpm. The time for performing spin coating on the ethanol solution of the 2-PACz is 25 s-35 s, including any point value within the numerical range. For example, the time for performing spin coating on the ethanol solution of the 2-PACz is 25 s, 26 s, 28 s, 30 s, 32 s, 34 s, or 35 s. An annealing temperature of the ethanol solution of the 2-PACz is 95 °C-105 °C, including any point value within the numerical range. For example, the annealing temperature of the ethanol solution of the 2-PACz is 95 °C, 98 °C, 100 °C, 102 °C, 104 °C, or 105 °C. An annealing time of the ethanol solution of the 2-PACz is 8 min-10 min, including any point value within the numerical range. For example, the annealing time of the ethanol solution of the 2-PACz is 8 min, 9 min, or 10 min.

Exemplarily, the perovskite cell includes a transparent conductive substrate, an electron transport layer, a perovskite thin film, a hole transport layer, and a top electrode. The perovskite cell may be of a n-i-p type (also referred to as cis) or a p-i-n type (also referred to as trans), but is not limited to the above structure.

In a fourth aspect, an embodiment of the present application provides a laminated cell, including the perovskite cell of the third aspect. Exemplarily, the laminated cell may be a crystalline silicon/perovskite laminated cell, a full perovskite laminated cell or a thin film cell (e.g., copper indium gallium selenide)/perovskite laminated cell.

The performance of the perovskite thin film prepared in the present application is introduced below with reference to embodiments. It should be understood that these embodiments are intended only to illustrate the present application and not to limit the scope thereof. For the experimental methods in the following examples in which specific conditions are not specified, preference should be given to the guidance provided in the present application. Alternatively, such methods may be carried out according to the experimental manuals or conventional conditions in the art, according to the conditions recommended by the manufacturer, or with reference to experimental methods known in the art.

### Embodiment 1

A method for preparing a perovskite thin film of this embodiment includes:
a layer of NiOₓ thin film was sputtered, through PVD, on a prepared crystalline silicon cell as a hole transport layer;
then, 1 mg of 2-PACz was added to 1 mL of an ethanol solution, spin coating was performed for 30 s at a rotary speed of 4000 rpm, and annealing was performed to obtain a passivation layer;
then, 2 mg of sodium formate was added to 1 mL of an ethanol solution, spin coating was performed for 30 s at a rotary speed of 4000 rpm, a density of a coated surface of the ethanol solution of the sodium formate was 20 µL/cm², and annealing was performed for 10 min at 100 °C to obtain a bottom buried layer;
multi-source vapor deposition of Pbl₂ was performed on the bottom buried layer, and then annealing was performed at 100 °C to form a Pbl₂ porous thin film; and
the Pbl₂ in the porous thin film reacted with an organic amine salt to obtain a perovskite thin film.

### Embodiment 2

A method for preparing a perovskite cell provided in this embodiment included the following steps:
a perovskite thin film was prepared, and a difference between this step and Embodiment 1 lied in that 1 mg of sodium formate was added to 1 mL of an ethanol solution, that is, a concentration of the sodium formate in the ethanol solution was 1 mg/mL;
an electron transport layer was prepared on the perovskite thin film;
a buffer layer was prepared on the electron transport layer;
a patterned transparent electrode was prepared on the buffer layer;
a positive electrode was prepared on the transparent electrode;
a back electrode was prepared on a back side of a crystalline silicon cell.

### Embodiment 3

A difference between this embodiment and Embodiment 1 lied in that a bottom buried layer was prepared by using potassium formate.

### Embodiment 4

A difference between this embodiment and Embodiment 2 lied in that 0.1 mg of sodium formate was added to 1 mL of an ethanol solution, that is, a concentration of the sodium formate was 0.1 mg/mL.

### Embodiment 5

A difference between this embodiment and Embodiment 1 lied in that 4 mg of sodium formate was added to 1 mL of an ethanol solution, that is, a concentration of the sodium formate was 4 mg/mL.

### Comparative example 1

A method for preparing a perovskite cell provided in this comparative example included the following steps:
a layer of NiOₓ thin film was sputtered, through PVD, on a prepared crystalline silicon cell as a hole transport layer;
then, 1 mg of 2-PACz was added to 1 mL of an ethanol solution, spin coating was performed for 30 s at a rotary speed of 4000 rpm, and annealing was performed to obtain a passivation layer;
multi-source vapor deposition of Pbl₂ was performed, and then annealing was performed at 100 °C to form a Pbl₂ porous thin film on the passivation layer;
the Pbl₂ thin film reacted with an organic amine salt to obtain a perovskite thin film;
an electron transport layer was prepared on the perovskite thin film;
a buffer layer was prepared on the electron transport layer;
a patterned transparent electrode was prepared on the buffer layer;
a positive electrode was prepared on the transparent electrode; and
a back electrode was prepared on a back side of a crystalline silicon cell.

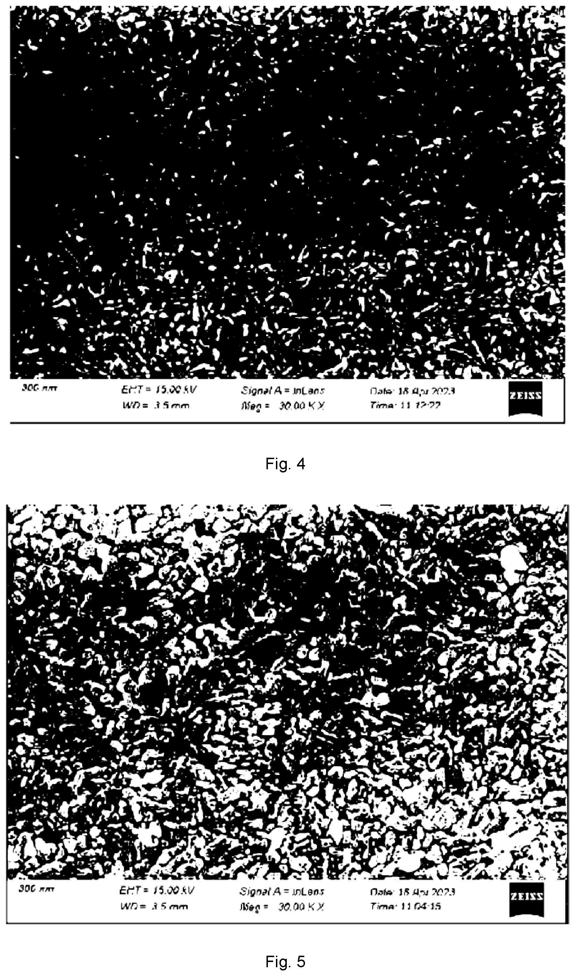

The Pbl₂ porous thin film of Embodiment 1 and the Pbl₂ porous thin film prepared in Comparative example 1 were respectively scanned by using an SEM, and obtained images were shown in Fig. 4 and Fig. 5. It might be learned from Fig. 4 that, there were virtually no regions of light and shade differences in the SEM image, and the entire image appeared to be nearly monochromatic, indicating that the Pbl₂ thin film in Comparative example 1 was relatively dense. Referring to Fig. 5, the SEM image in Fig. 5 showed more regions of light and shade differences, and a region that was darker than the surrounding image was a porous structure, indicating that the Pbl₂ porous thin film of Embodiment 1 had an apparent porous structure. Holes in the image are passages for organic amine cation or alkali metal cation to enter a metal halide thin film, thereby allowing metal halide in the porous thin film to fully react.

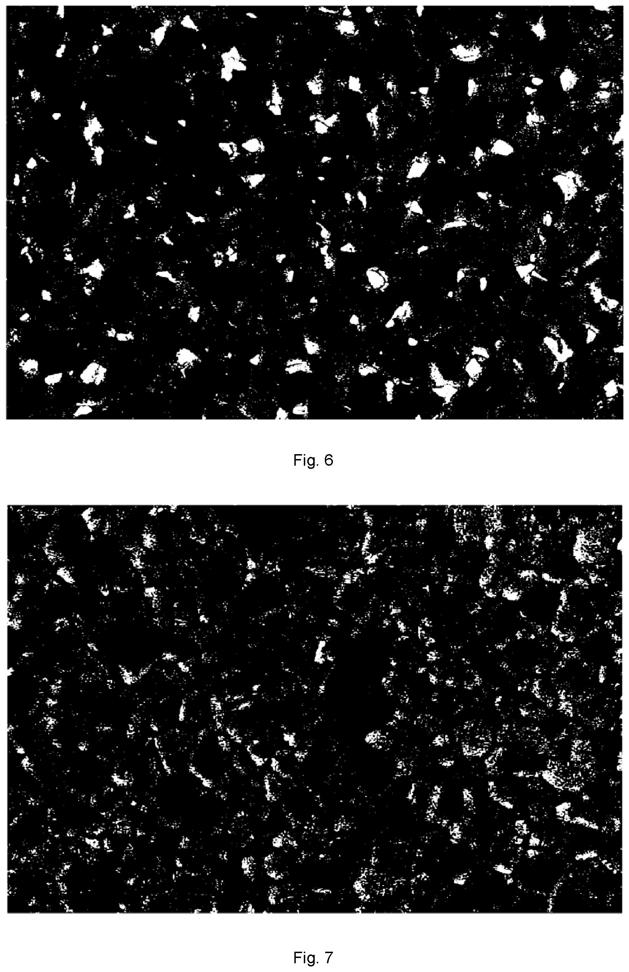

The perovskite thin films prepared in Embodiment 1, Embodiment 4, and Embodiment 5 were respectively scanned by the SEM, and obtained images were shown in Fig. 6 to Fig. 8. Referring to Fig. 6, Fig. 6 was an SEM diagram of a perovskite thin film according to Embodiment 4 of the present application. The concentration of the sodium formate in Embodiment 4 was 0.1 mg/mL. When the concentration of the sodium formate was relatively low, the morphology of the resulting Pbl₂ thin film may not change significantly, leading to lead iodide residues in the finally-prepared perovskite thin film. White patches were found in the SEM image.

Referring to Fig. 7, Fig. 7 was an SEM diagram of a perovskite thin film according to Embodiment 1 of the present application. The concentration of the sodium formate in Embodiment 1 was 2 mg/mL. The prepared perovskite thin film contained virtually no residual lead iodide, was large in grain size, and was dense. Compared to Fig. 6, no white patches were found in Fig. 7.

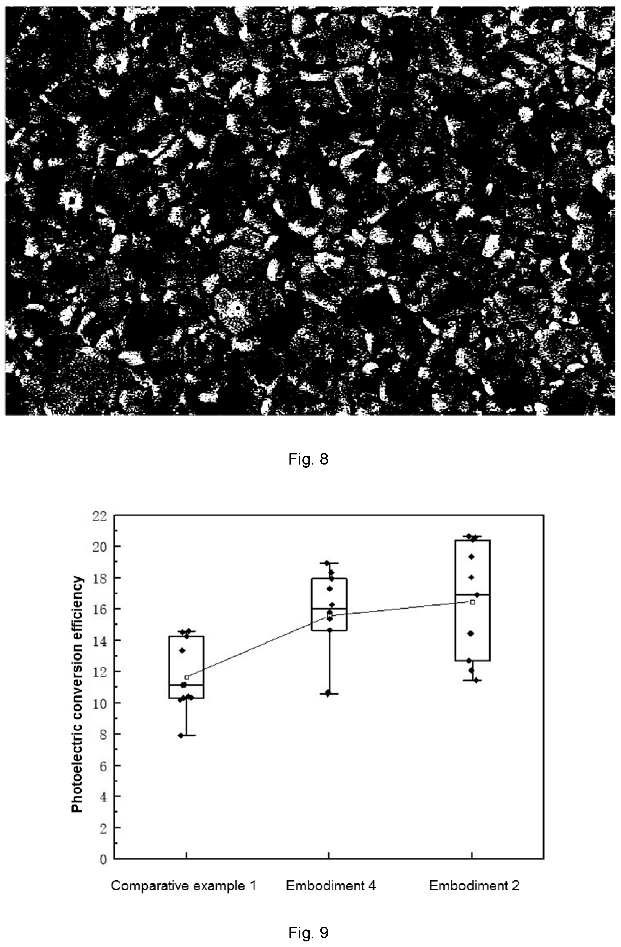

Referring to Fig. 8, Fig. 8 was an SEM diagram of a perovskite thin film according to Embodiment 5 of the present application. The concentration of the sodium formate in Embodiment 5 was 4 mg/mL, and when the concentration of sodium formate is relatively high, the Pbl₂ thin film may become excessively loose, resulting in partial pore defects in the prepared perovskite thin film. Referring to Fig. 8, the SEM image of the perovskite thin film showed pinhole-shaped hole defects, and these hole defects may affect the performance of the perovskite cell prepared subsequently.

The PCE of the perovskite batteries in Embodiment 2, Comparative example 1, and Embodiment 4 were detected, and obtained test results were shown in Fig. 9. From the figure, it might be learned that the bottom buried layer containing the sodium formate was not added in Comparative example 1, and the PCE of the finally-prepared perovskite cell was relatively low, indicating that it was difficult for organic cation applied via spin coating to fully react with the Pbl₂, thus resulting in excessive Pbl₂ residue at the bottom. The excess unreacted Pbl₂ severely affected the performance of photovoltaic cells. The bottom buried layer containing the sodium formate was added in Embodiment 4, but the concentration of the sodium formate was 0.1 mg/mL. In this case, the PCE of the perovskite cell had been improved to a certain extent compared to that in Comparative example 1. In Embodiment 2, the concentration of the sodium formate was 1 mg/mL, which was higher than that in Embodiment 4, and thus the PCE of the perovskite cell in Embodiment 2 was higher than that in Embodiment 4. It might be understood that, the concentration of the sodium formate was increased within an appropriate range, causing the prepared Pbl₂ porous thin film to have a more significant porous structure. The porous structure was a passage for the organic amine cation or alkali metal cation to enter the metal halide thin film, causing the metal halide in the porous thin film to fully react, thereby further improving the PCE of the perovskite cell.

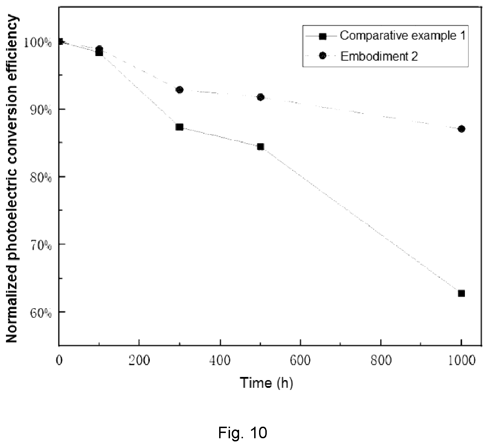

At room temperature of 25 °C and humidity of 10%, a relationship between normalized PCE and time of the perovskite batteries prepared in Embodiment 2 and Comparative example 1 was tested. Referring to Fig. 10, it was known that excessive unreacted Pbl₂ severely affected the performance of the photovoltaic cells and accelerated device degradation. More lead iodide residues were contained in the perovskite thin film in Comparative example 1, leading to rapid aging of a device. The perovskite thin film in Embodiment 2 contained virtually no residual lead iodide, such that the stability of the device was good, and the aging of the device was slow.

The method for preparing a perovskite thin film, thin film, perovskite cell, and laminated cell disclosed in the embodiments of the present application are introduced in detail above. Detailed examples are used in this specification to describe the principles and implementations of the present application. The description of the above embodiments is merely used to facilitate understanding of the method for preparing a perovskite thin film, thin film, perovskite cell, and laminated cell of the present application and the core idea thereof. In addition, for those of ordinary skill in the art, according to the idea of the present application, there will be changes in the specific implementations and the scope of application. In summary, the content of this specification should not be construed as a limitation of the present application.

## Claims

1. A method for preparing a perovskite thin film, wherein the preparation method comprises:
preparing a bottom buried layer, wherein the bottom buried layer comprises alkali metal formate;
forming, on the bottom buried layer, a porous thin film containing a compound with a chemical formula being BX₂; and
allowing the compound with the chemical formula being BX₂ in the porous thin film to react with a compound with a chemical formula being AX to obtain a perovskite thin film, wherein
B is a metal cation, A is an organic amine cation or an alkali metal cation, and X is a halogen ion or a halogen-like anion.

2. The method for preparing the perovskite thin film according to claim 1, wherein a step of preparing the bottom buried layer comprises:
adding the alkali metal formate to a first solvent to obtain a first solution; and
coating the first solution on a substrate to obtain the bottom buried layer.

3. The method for preparing the perovskite thin film according to claim 2, wherein a concentration of the alkali metal formate in the first solution is about 1 mg/mL to about 2 mg/mL.

4. The method for preparing the perovskite thin film according to claim 2 or 3, wherein a density of a coated surface of the first solution is about 10 µL/cm² to about 25 µL/cm².

5. The method for preparing the perovskite thin film according to any one of claims 2 to 4, wherein the first solvent comprises at least one of ethanol and octanol.

6. The method for preparing the perovskite thin film according to any one of claims 2 to 5, wherein a step of coating the first solution on the substrate to obtain the bottom buried layer comprises:
performing spin coating with the first solution for about 25 s to about 35 s at a rotary speed of about 3500 rpm to about 4500 rpm, and performing annealing for about 8 min to about 10 min at about 95 °C to about 105 °C.

7. The method for preparing the perovskite thin film according to any one of claims 1 to 6, wherein a step of forming, on the bottom buried layer, the porous thin film containing the compound with the chemical formula being BX₂ comprises:
performing, on the bottom buried layer, multi-source vapor deposition on the compound with the chemical formula being BX₂ to form a film layer, wherein a thickness of the film layer is about 200 nm to about 400 nm; and
performing annealing on the film layer at about 95 °C to about 105 °C to form the porous thin film.

8. The method for preparing the perovskite thin film according to any one of claims 1 to 7, wherein a step of allowing the compound with the chemical formula being BX₂ in the porous thin film to react with the compound with the chemical formula being AX to obtain the perovskite thin film comprises:
coating a second solution on the porous thin film, wherein the second solution comprises the compound with the chemical formula being AX.

9. The method for preparing the perovskite thin film according to any one of claims 1 to 8, wherein an alkali metal in the alkali metal formate comprises at least one of lithium, sodium, potassium, rubidium, and cesium.

10. The method for preparing the perovskite thin film according to any one of claims 1 to 9, wherein the alkali metal formate comprises at least one of lithium formate, sodium formate, potassium formate, rubidium formate, and cesium formate.

11. The method for preparing the perovskite thin film according to any one of claims 1 to 10, wherein the metal cation comprises at least one of Pb₂⁺ and Sn₂⁺.

12. The method for preparing the perovskite thin film according to any one of claims 1 to 11, wherein the organic amine cation comprises at least one of CH₃NH₃⁺ and NH₂CH=NH₂⁺.

13. The method for preparing the perovskite thin film according to any one of claims 1 to 12, wherein the alkali metal cation comprises at least one of Cs⁺ and Rb⁺.

14. The method for preparing the perovskite thin film according to any one of claims 1 to 13, wherein the halogen ion comprises at least one of Cl⁻, Br, and I⁻.

15. The method for preparing the perovskite thin film according to any one of claims 1 to 14, wherein the halogen-like anion comprises at least one of CN⁻, SCN⁻, OCN⁻, and SeCN⁻.

16. A thin film, comprising a perovskite thin film prepared by the method for preparing the perovskite thin film according to any one of claims 1 to 15.

17. A perovskite cell, comprising the thin film according to claim 16.

18. A laminated cell, comprising the perovskite cell according to claim 17.
